(19)

Europäisches Patentamt

European Patent Office

Office européen des brevets

(11) **EP 1 195 352 A1**

(12) **EUROPEAN PATENT APPLICATION**

(43) Date of publication:
**10.04.2002 Bulletin 2002/15**

(51) Int Cl.⁷: **B81C 1/00**, H01L 29/04

(21) Application number: **00870227.6**

(22) Date of filing: **09.10.2000**

(84) Designated Contracting States:
**AT BE CH CY DE DK ES FI FR GB GR IE IT LI LU
MC NL PT SE**
Designated Extension States:
**AL LT LV MK RO SI**

(71) Applicants:
• **Interuniversitair Micro-Elektronica Centrum
3001 Heverlee (BE)**
• **EASTMAN KODAK COMPANY
Rochester, New York 14650 (US)**

(72) Inventors:
• **Witvrouw, Ann
3020 Herent (BE)**
• **De Vries, Atze
3000 Leuven (BE)**

• **De Moor, Piet
3210 Linden-Lubbeek (BE)**
• **Haspelagh, Luc
3210 Linden-Lubbeek (BE)**
• **Parmentier, Brigitte
3001 Leuven (BE)**
• **Verbist, Agnes
3020 Winksele-Herent (BE)**
• **Anagnostopoulos, Constantine
Mendon, New York 14506 (US)**

(74) Representative: **Van Malderen, Joelle et al
Office Van Malderen,
Place Reine Fabiola 6/1
1083 Bruxelles (BE)**

(54) **A method for producing micromachined devices and devices obtained thereof**

(57) The present invention is related to a method for producing micromachined devices for use in Microelectromechanical Systems (MEMS), comprising the steps of providing a crystalline wafer (1), and processing from said wafer at least one micromachined device (5) so that openings and/or cavities (4) on said at least one micromachined device are not parallel to a direction which lies along the intersection of the front plane of the wafer and a cleavage plane, said cleavage plane being defined as a plane along which cleavage of the wafer is most likely to occur.

FIG. 3a

## Description

### Field of the invention

The present invention is related to a method for producing micromachined devices for use in Microelectromechanical Systems (MEMS). The present invention is also related to the devices obtained by said method and the use of said devices.

### State of the art

In Microelectromechanical Systems (MEMS), also known as Microsystems or Micro Machined Systems, devices are often used, the production of which is based on the method technology developed in semiconductor processing, combined with specific MEMS technology. In MEMS technology, structures such as beams or cavities, can be added to micro-electronic circuitry. Compared to standard semiconductor devices, the mechanical properties of these micromachined devices are subject to very demanding criteria, in terms of breaking behaviour, weight, vibration resistance, etc, which is imposing higher standards on the processing of these devices.

To produce certain types of micromachined devices, the method of bulk micromachining is used, wherein wells are etched in a semiconductor wafer, leaving membranes, openings or beams. This leads for example to pressure sensors, accelerometers, inclinometers, or optical devices.

In the case of bulk micromachined accelerometers for example, openings are etched in the semiconductor wafer. Often, these openings are large and narrow, resembling elongated cracks in the wafer.

In general, it is true that cavities or openings are formed in micromachined devices, which are large and deep in comparison to openings normally defined in semiconductor processing, such as contact or via holes, which have a diameter typically less than 5 μm and a depth less than 2μm. Such large openings or cavities are responsible for a weakening of the wafer and increase the chance of the wafer breaking under the influence of stresses induced for example during processing.

### Aims of the invention

The present invention aims to provide a method for producing micromachined devices which have a higher resistance to crack propagation during and after processing.

A further aim of the present invention is to provide micromachined devices having improved resistance to crack propagation.

### Summary of the invention

The present invention is related to a method for producing micromachined devices for use in Microelectromechanical Systems (MEMS), comprising the steps of:

- providing a crystalline wafer,
- processing from said wafer at least one micromachined device so that openings and/or cavities on said at least one micromachined device are not parallel to a direction which lies along the intersection of the front plane of the wafer and a cleavage plane, said cleavage plane being defined as a plane along which cleavage of the wafer is most likely to occur.

The present invention is related in particular to a method, wherein said wafer has the shape of a circular disc, with at least one part cut off along a chord of said circular disc, the longest of said chords being called 'the flat' of said wafer.

According to a first preferred embodiment of the present invention, said flat is oriented along said intersection.

According to a second preferred embodiment of the present invention, said flat is not oriented along said intersection.

In a preferred embodiment of the present invention, said wafer is a silicon wafer, whose front and back surfaces are oriented along a plane of the {100} family and wherein said cleavage plane is a plane belonging to the {111} or the {110} family.

In the embodiment wherein said flat is oriented along said intersection, the method according to the invention comprises the steps of:

- subjecting said wafer to a photolithography step, whereby a pattern is printed through a mask onto said wafer,
- etching said wafer,

wherein said photolithography step comprises the step of rotating said mask over an angle, with respect to said wafer, or wherein said pattern is positioned at an angle with respect to said mask, or wherein said photolithography step comprises the step of rotating said wafer over an angle with respect to said mask.

According to the embodiment wherein said flat is oriented along said intersection, said photolithography step may comprise a contact printing step or a proximity printing step.

In the embodiment wherein said flat is not oriented along said intersection, the method according to the invention comprises the steps of:

- subjecting said wafer to a photolithography step, whereby a pattern is printed through a mask onto said wafer,

- etching said wafer,

wherein said photolithography step may comprise a contact printing step, a proximity printing step or a number of projection printing steps.

The present invention is also related to a micromachined device for use in Microelectromechanical Systems, said device being produced according to the method of the invention.

The present invention is also related to the use of a micromachined device, said device being produced according to the method of the invention.

## Short description of the drawings

Figure 1a describes the orientation of the dies on a standard {100} Si-wafer in standard processing.

Figure 1b describes an alternative form of a standard {100} Si-wafer.

Figure 1c shows an alternative pattern of devices on a standard wafer.

Figure 2a shows a standard {100} Si-wafer with a long and narrow opening etched out.

Figure 2b shows the wafer of figure 2a, after cleavage.

Figure 3a shows a standard {100} Si-wafer wherein the device to be produced is tilted over an angle θ with respect to the flat.

Figure 3b shows the situation of fig. 3a wherein θ = 45°.

Figure 4 shows a wafer wherein the device is parallel to the flat, but device and flat are tilted over an angle θ with respect to <110>.

Figure 5 shows a wafer wherein dies are printed using a step-and-repeat projection printing step in the photolithography.

## Detailed description of the invention

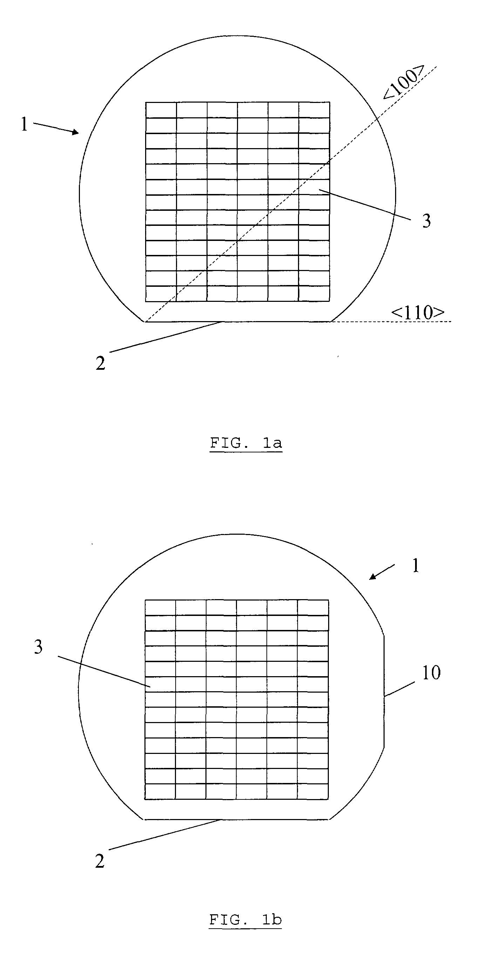

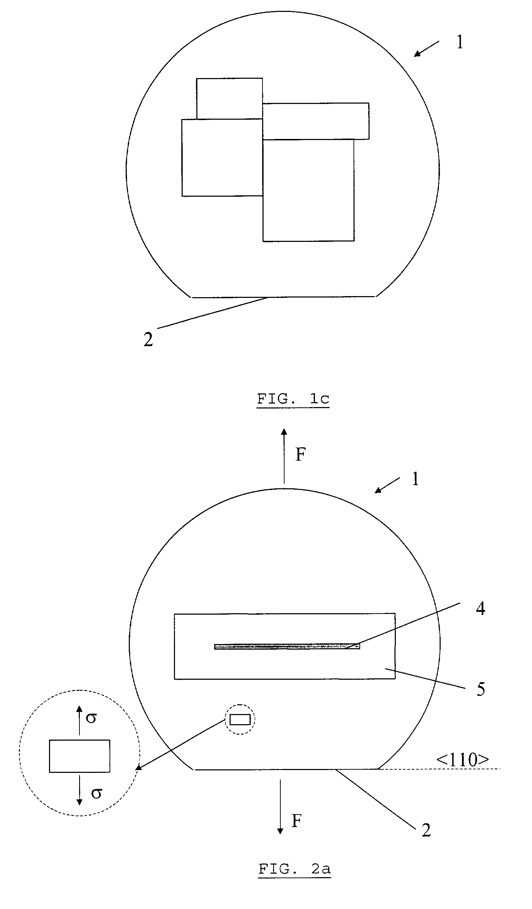

As shown in figure 1a, semiconductor wafers are mostly delivered in the form of circular shaped flat discs 1, with a straight edge or 'flat' 2 along a chord of the circular disc, said flat being used for positioning the wafer during processing. An additional straight edge 10 may be present, as shown in figure 1b, which is however shorter in length than the flat 2. In the following, the term 'flat' refers to the longest straight edge of a wafer.

In the case of standard semiconductor devices, a wafer is partitioned into a number of 'dies' 3, which, after processing, will be separated into single chips. The partitioning into dies of equal dimensions is typical for devices produced on the basis of a projection printing process, such as step-and-repeat printing. Other printing processes, such as those using a contact or proximity printer, allow other configurations, such as the one shown in figure 1c. We will however base the following description on the exemplary case of figure 2a, wherein the micromachining consists of producing a device 5 containing a long and narrow opening 4, from a wafer 1 with flat 2.

Under the influence of a load applied to the wafer, such as mechanical or thermal forces or shocks, the opening 4 may propagate, leading to breaking of the wafer. Breaking will occur along a so-called cleavage plane. The question whether or not the wafer will break and along which cleavage plane, depends on the form of the opening, the stress applied, and on the orientation of the wafer's crystal structure with respect to the opening. It is the stress concentration around crack tips or other discontinuities which causes wafers to break even though they are subjected to an overall stress level, which is far below the material's yield strength.

In general, when a crack of length 2c is formed in a material, subjected to a stress σ in the homogenous material, a stress intensity factor K is used, to numerically evaluate the eventuality of crack propagation. This will be illustrated (see figure 2a) for the exemplary case of a tensile stress σ in a silicon wafer, caused by external tensile forces F. It is understood that the stress σ is the tensile stress in the homogenous material, at a sufficiently large distance from the opening 4. It is a known fact that in the vicinity of discontinuities (sharp edges, crack tips) the stress level will rise to very high local values, exceeding by far the value σ in the homogenous material. This is why, at acceptable levels of the stress in the homogenous material, breaking of the wafer can be initiated at the edges of openings such as opening 4.

This stress intensity factor K (expressed in $MPA\sqrt{m}$) is given by

$$K = \sigma\sqrt{c\pi} \qquad (1)$$

Once the stress intensity factor exceeds a critical value $K_c$, the crack will be propagated. This can equally be expressed in terms of a critical applied stress level $\sigma_c$ in the homogenous material:

$$\sigma_c = \frac{K_c}{\sqrt{c\pi}} \qquad (2)$$

When σ exceeds $\sigma_c$, crack propagation begins.

In micromachined devices, silicon is a widely used material. It has excellent mechanical properties apart from significant photoelectric and thermoelectric effects and a reasonable carrier mobility.

Many of these properties are related to the crystalline structure of silicon. The atoms in a silicon wafer form a lattice structure, which, viewed from different angles reveals different patterns of atoms. The planes and directions in a Si-wafer are represented by their Miller indices, which are known in the art.

Three families of planes: {100}, {110} and {111} are important in silicon wafers. Standard Si-wafers are of the {100} type, meaning that their flat front and back surfaces are oriented along a plane belonging to the {100} family. Also in standard Si-wafers, the flat 2 is oriented along a <110> direction which is the common intersection direction between on the one hand planes of the {100} and {110} families and on the other hand of planes of the {100} and {111} families. Figure 1a also shows the <100> direction, which is the common intersection between on the one hand two planes of the {100} family and on the other hand planes of the {100} and {110} families. The failure of Si-wafers as a consequence of the stress concentrations described above, occurs by a phenomenon called cleavage: this means that the wafer breaks in two along a well defined cleavage plane that depends on the orientation of the stress with respect to the wafer's crystal structure.

In silicon, the value of $K_c$ has been measured for cleavage along the three main Miller index plane families, resulting in the data of table 1 (P.J. Burnett, 'Properties of Silicon', EMIS datareview series no. 4, INSPEC, London, UK, 1988, p. 30). This can be interpreted as the likelihood of the wafer cleaving along a plane belonging to each of the three families mentioned.

It is clear that the {100} family offers the most resistance to cleavage in the presence of a stress concentration, followed by {110} and {111} in that order. However, this doesn't mean that cleavage necessarily occurs along a plane of the {111} family, as will be explained after this.

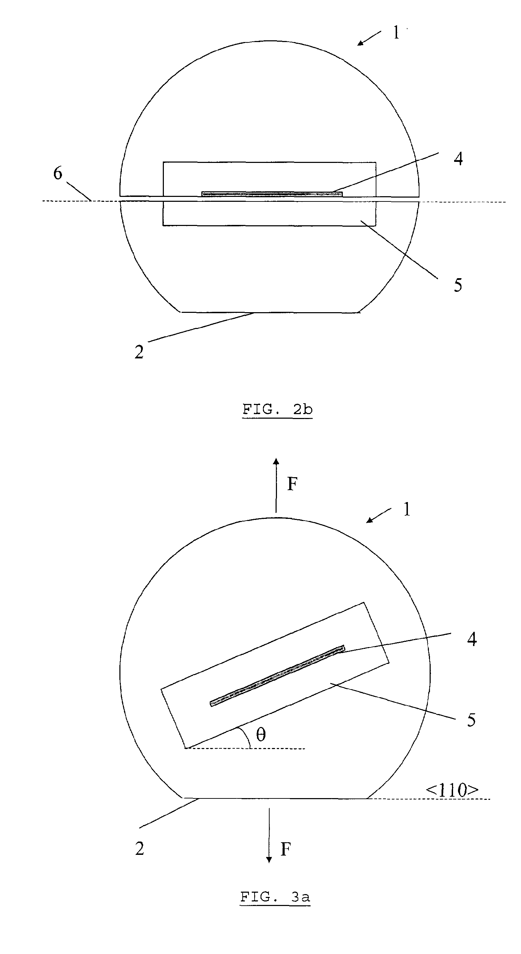

As stated above, the flat of standard Si-wafers is oriented along the <110> direction. Suppose that the opening 4 is now parallel to said flat, as shown in figure 2a. Even a relatively low tensile stress σ, as shown in figure 2a, will cause a critical stress at the tip of the opening. If a critical stress level is reached, cleavage will occur along the line 6 of figure 2b. The cleavage plane depends on the orientation of the stress and the type of stress. A tensile stress or a bending stress may cause cleavage along a plane of the {110} or {111} families. This is because not only the $K_c$ factor is important, but also the projection of the stress perpendicular to the cleavage plane. To decrease the chance of cleavage along any of these planes, the present invention now proposes the following solutions.

The present invention proposes a method of processing a wafer, wherein openings are etched at an angle θ with respect to the direction <110>, so that crack propagation is inhibited.

Figure 2a shows the standard situation. The opening 4 is oriented along the <110> direction. Under the influence of a tensile stress σ, perpendicular to <110>, cleavage will occur as soon as a critical stress level is reached.

Figure 3a shows a first alternative, whereby the device 5 and the opening 4 have been rotated over an angle θ, with respect to <110>. Returning to the exemplary case of a tensile stress perpendicular to the flat, it is now the projection of the crack length 2c on the <110> direction which is to be taken into consideration in order to assess the chance of cleavage along the same plane as in figure 2b.

Such cleavage will now occur starting from a higher stress level $\sigma_c$':

$$\sigma_c' = \frac{K_c}{\sqrt{c\pi \, \cos\theta}} \qquad (3)$$

which is an increase by a factor $\sqrt{1/\cos\theta}$ compared to equation (2). This way, the chance of failure of the wafer by cleavage along the same plane as in figure 2b has diminished.

The optimal value of θ depends on the material used. In the case of silicon for example, the orientation along θ will decrease the chance of cleavage along one plane, but care must be taken that cleavage will not occur along another plane.

This may happen when the projection of the stress on the direction perpendicular to the opening 4, becomes high enough to initiate cleavage along another plane than the one that was 'reinforced' by tilting the opening 4.

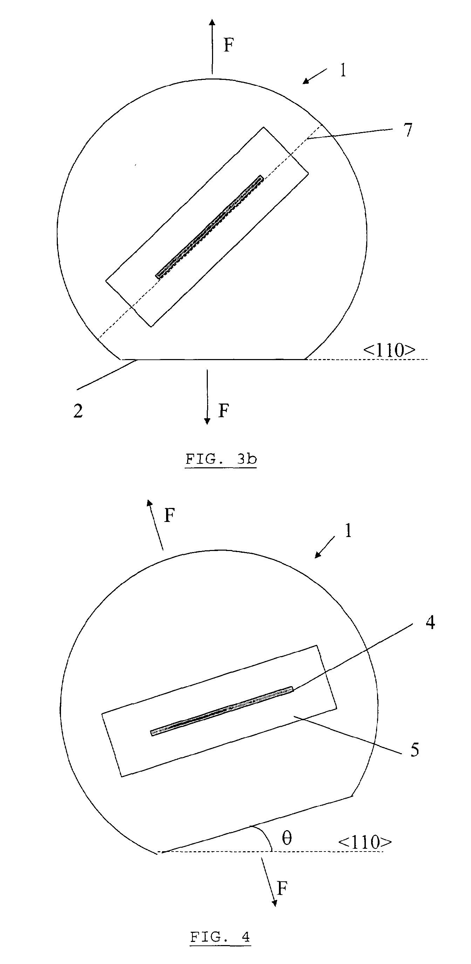

For Si-wafers, the optimal value of θ is lying between 0° and 45°: at 45°, the opening lies along the <100> direction, which may lead to cleavage along another plane of the {110} family and along a line 7 shown in figure 3b.

Figure 4 illustrates the second alternative, wherein the flat of the wafer is no longer oriented along the <110>, but along a direction which is at an angle θ with respect to that <110> direction. The device 5 and the opening 4 remain parallel to the flat, as in the case of standard wafers.

To have a similar situation than the previous, the wafer of figure 4 is once again subjected to a tensile stress σ perpendicular to the flat. To assess the chance of the wafer breaking along the same cleavage plane as before, the relevant crack length to be taken into consideration is the projection of the real crack length 2c on the <110> direction. However, this projected length is now subjected to the projection of σ on the direction perpendicular to <110>. This means that cleavage will now occur when:

$$\sigma \cos\theta \rangle \frac{K_c}{\sqrt{\pi c \, \cos\theta}} \qquad (4)$$

meaning:

$$\sigma \rangle \frac{K_c}{\cos\theta . \sqrt{\pi c \, \cos\theta}} \qquad (5)$$

In this case, the critical stress at which cleavage along the same plane as in figure 2b occurs is further increased by a factor 1/cosθ.

Based on the two effects described above, two preferred embodiments of the method according to the invention are proposed. According to both embodiments, a wafer is subjected to a process comprising the steps of photolithography and etching, known in the art. The photolithography entails the printing of a pattern of dies, such as shown in figure 1a or 1c onto a wafer. This printing step may be performed in different ways. In all cases, the pattern to be printed is produced on a so-called mask, to be placed between a light source and the wafer, in order to print the pattern onto said wafer. In one type of printing, the mask is placed in contact with or very close to the wafer. This is called contact or proximity printing respectively, which are used preferably to print a complete set of dies (as in figures 1a or 1c). On the other hand, projection printing methods exist, whereby an optical system is employed between the mask and the wafer, which allows the printed pattern to be reduced in size with respect to the pattern on the mask. This last method is preferably used when a number of different dies with equal size are printed next to each other on the same wafer, a process also called step-and-repeat printing.

In a first preferred embodiment, illustrated in figure 3a, openings are oriented on a standard wafer so that they are placed at an angle θ with respect to the flat and thus to the <110> direction.

According to this embodiment, micromachined devices are produced by a method comprising the steps of photolithography and etching of a Si-wafer, wherein the photolithography step preferably comprises a contact or proximity printing step. To acquire the tilting of the complete set of dies over an angle θ, different actions can be undertaken: the mask can be rotated over that angle with respect to a stationary wafer, prior to photo-exposure of the pattern. This would of course require a printing device which allows such a rotation. Alternatively, the pattern on the mask may placed in a tilted position, at an angle θ with respect to the mask, and then printed through the mask while the mask is in its standard position. This allows the use of a standard printing device. Finally, the wafer itself can be rotated over θ, with respect to a stationary and standard printing device and standard mask. The wafer used in this embodiment of the invention is a standard wafer, with the flat oriented along the <110> direction.

In a second embodiment, illustrated in figure 4, openings are parallel to the flat, but the flat itself is tilted at an angle θ with respect to the <110> direction. This type of wafer is not standard and needs to be produced especially in this way.

According to this embodiment, the production method of micromachined devices comprises equally the classic photolithography and etching steps, whereby the photolithography step may equally comprise a contact or proximity printing step. The tilted orientation of the flat with respect to the weaker <110> direction, permits the printing of the set of dies, according to standard processing methods, without necessitating the rotation of the mask, nor of the wafer.

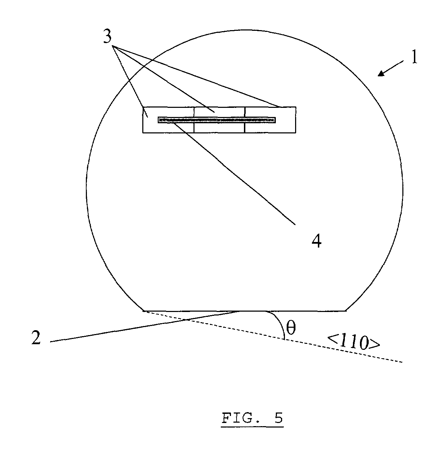

Apart from that, the method according to the second embodiment of the invention is especially suitable for a method wherein the photolithography is based on projection printing, such as step-and-repeat printing, as illustrated in figure 5. As was stated before, this type of printing step is mostly used to acquire a set of dies 3 of identical dimensions, such as shown in figures 1a and 1b. In step-and-repeat printing, the dies 3 are printed separately and consecutively onto the wafer 1. To obtain an orientation of the die and/or the openings defined on it, on a standard wafer (i.e. with the flat parallel to <110>), it would be necessary to perform additional translation/rotation of the wafer between printing steps, in order to align the different dies, which would make the method more complex and time-consuming. With the wafer used in the method according to this embodiment, whereby the flat is not oriented along the <110> direction, the wafer can be processed in the classic way, without additional translation or rotation between printing steps.

Table 1

| Miller index plane | {100} | {110} | {111} |
|---|---|---|---|
| Kc ($MPA\sqrt{m}$MPA) | 0.95 | 0.9 | 0.82 |

**Claims**

1. A method for producing micromachined devices for use in Microelectromechanical Systems (MEMS), comprising the steps of:

   - providing a crystalline wafer (1),
   - processing from said wafer at least one micromachined device (5) so that openings and/ or cavities (4) on said at least one micromachined device are not parallel to a direction which lies along the intersection of the front plane of the wafer and a cleavage plane, said cleavage plane being defined as a plane along which cleavage of the wafer is most likely to occur.

2. A method according to claim 1, wherein said wafer (1) has the shape of a circular disc, with at least one part cut off along a chord of said circular disc, the longest of said chords being called 'the flat' (2) of said wafer.

3. A method according to claim 2, wherein said flat (2) is oriented along said intersection.

4. A method according to claim 2 wherein said flat (2) is not oriented along said intersection.

**5.** A method according to any one of the preceding claims, wherein said wafer (1) is a silicon wafer, whose front and back surfaces are oriented along a plane of the {100} family and wherein said cleavage plane is a plane belonging to the {111} family.

**6.** A method according to any one of the preceding claims, wherein said wafer (1) is a silicon wafer, whose front and back surfaces are oriented along a plane of the {100} family and wherein said cleavage plane is a plane belonging to the {110} family.

**7.** A method according to claim 3, 5 or 6, wherein said processing comprises the steps of

- subjecting said wafer (1) to a photolithography step, whereby a pattern is printed through a mask onto said wafer,
- etching said wafer,

**characterised in that** said photolithography step comprises the step of rotating said mask over an angle, with respect to said wafer.

**8.** A method according to claim 3, 5 or 6, wherein said processing comprises the steps of

- subjecting said wafer (1) to a photolithography step, whereby a pattern is printed through a mask onto said wafer,
- etching said wafer,

wherein said pattern is positioned at an angle with respect to said mask.

**9.** A method according to claim 3, 5 or 6, wherein said processing comprises the steps of

- subjecting said wafer to a photolithography step, whereby a pattern is printed through a mask onto said wafer,
- etching said wafer,

**characterised in that** said photolithography step comprises the step of rotating said wafer over an angle with respect to said mask.

**10.** A method according to claims 7, 8 or 9, wherein said photolithography step comprises a contact printing step.

**11.** A method according to claims 7, 8 or 9, wherein said photolithography step comprises a proximity printing step.

**12.** A method according to claim 4, 5 or 6, wherein said processing comprises the steps of:

- subjecting said wafer to a photolithography step, whereby a pattern is printed through a mask onto said wafer,
- etching said wafer,

**13.** A method according to claim 12, wherein said photolithography step comprises a number of projection printing steps.

**14.** A method according to claim 12, wherein said photolithography step comprises a contact printing step.

**15.** A method according to claim 12, wherein said photolithography step comprises a proximity printing step.

**16.** A micromachined device for use in Microelectromechanical Systems, said device being produced according to the method described in claims 1 to 15.

**17.** Use of a micromachined device in Microelectromechanical Systems, said device being produced according to the method described in claims 1 to 15.

FIG. 1a

FIG. 1b

FIG. 1c

F

1

4

5

σ

σ

<110>

F

2

FIG. 2a

FIG. 2b

FIG. 3a

FIG. 3b

FIG. 4

FIG. 5

## EUROPEAN SEARCH REPORT

**European Patent Office**

**Application Number**

EP 00 87 0227

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 658 927 A (ANT NACHRICHTENTECHNIK) 21 June 1995 (1995-06-21) * figures * | 1-3,6,12 | B81C1/00 H01L29/04 |
| X | US 4 969 359 A (FORD MOTOR) 13 November 1990 (1990-11-13) * figures * | 1-3,6, 12,16,17 | |
| X | EP 0 562 880 A (NEC) 29 September 1993 (1993-09-29) * figure 13 * | 1-3,5,6 | |
| X | US 4 278 987 A (HITACHI) 14 July 1981 (1981-07-14) * figure 6 * | 1-3,5,6 | |
| X | DE 34 35 138 A (SIEMENS) 3 April 1986 (1986-04-03) * figures * | 1-3,6 | |
| X | PATENT ABSTRACTS OF JAPAN vol. 015, no. 502 (E-1147), 18 December 1991 (1991-12-18) -& JP 03 219618 A (SONY CORP), 27 September 1991 (1991-09-27) * abstract * | 1-3,6, 12,13 | TECHNICAL FIELDS SEARCHED (Int.Cl.7) B81C H01L |

The present search report has been drawn up for all claims

| Place of search | Date of completion of the search | Examiner |
|---|---|---|
| THE HAGUE | 12 March 2001 | Gori, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 1 195 352 A1**

## ANNEX TO THE EUROPEAN SEARCH REPORT
## ON EUROPEAN PATENT APPLICATION NO.

EP 00 87 0227

This annex lists the patent family members relating to the patent documents cited in the above-mentioned European search report.
The members are as contained in the European Patent Office EDP file on
The European Patent Office is in no way liable for these particulars which are merely given for the purpose of information.

12-03-2001

| Patent document cited in search report | | Publication date | Patent family member(s) | | Publication date |
|---|---|---|---|---|---|
| EP 658927 | A | 21-06-1995 | DE 4342767 | A | 22-06-1995 |
| US 4969359 | A | 13-11-1990 | US 4981552 | A | 01-01-1991 |
| EP 562880 | A | 29-09-1993 | DE 69312360 | D | 28-08-1997 |
| | | | DE 69312360 | T | 20-11-1997 |
| | | | JP 6013650 | A | 21-01-1994 |
| | | | US 5349211 | A | 20-09-1994 |
| US 4278987 | A | 14-07-1981 | JP 55030844 | A | 04-03-1980 |
| | | | JP 54057865 | A | 10-05-1979 |
| | | | DE 2845062 | A | 19-04-1979 |
| | | | US 4362599 | A | 07-12-1982 |
| DE 3435138 | A | 03-04-1986 | NONE | | |
| JP 03219618 | A | 27-09-1991 | NONE | | |

EPO FORM P0459